# EUROPÄISCHE PATENTSCHRIFT

(11) **EP 1 423 551 B1**
(45) Veröffentlichungstag und Bekanntmachung des Hinweises auf die Patenterteilung: **22.07.2009**
(21) Anmeldenummer: 02769887.7
(22) Anmeldetag: 22.08.2002
(51) Int. Cl.: C23C 14/06, C23C 16/30, C23C 14/35

(54) **VERFAHREN ZUR ERZEUGUNG EINER NANOSTRUKTURIERTEN BESCHICHTUNG**
METHOD FOR PRODUCING A NANOSTRUCTURED FUNCTIONAL COATING AND A COATING THAT CAN BE PRODUCED ACCORDING TO SAID METHOD
PROCEDE POUR PRODUIRE UN REVETEMENT FONCTIONNEL NANOSTRUCTURE ET REVETEMENT POUVANT ETRE PRODUIT PAR CE PROCEDE

(30) Priorität: 25.08.2001 DE 10141696
(43) Veröffentlichungstag der Anmeldung: 02.06.2004
(73) Patentinhaber: ROBERT BOSCH GMBH, 70442 Stuttgart (DE); WALTER AG, 72010 Tübingen (DE)
(72) Erfinder: BECK, Thomas, 71737 Kirchberg (DE); SCHATTKE, Alexander, 70499 Stuttgart (DE); HENKE, Sascha, 71263 Weil Der Stadt (DE); SCHIER, Veit, 70771 Echteringen (DE)
(86) Internationale Anmeldenummer: PCT/DE2002/003074
(87) Internationale Veröffentlichungsnummer: WO 2003/018862

(56) Entgegenhaltungen:
- DE-A- 19 824 364
- DE-C- 4 324 683
- MONTEIRO O R ET AL: "Synthesis and characterization of thin films of WC/sub x/ produced by mixing W and C plasma streams" 24TH INTERNATIONAL CONFERENCE ON METALLURGICAL COATINGS AND THIN FILMS, SAN DIEGO, CA, USA, 21-25 APRIL 1997, Bd. 94-95, Nr. 1-3, Seiten 220-225, XP002226792 Surface and Coatings Technology, Oct. 1997, Elsevier, Switzerland ISSN: 0257-8972
- HIRASAWA M ET AL: "SYNTHESIS OF GAAS NANOPARTICLES BY DIGITAL RADIO FREQUENCY PUTTERING" APPLIED PHYSICS LETTERS, AMERICAN INSTITUTE OF PHYSICS. NEW YORK, US, Bd. 67, Nr. 23, 4. Dezember 1995 (1995-12-04), Seiten 3483-3485, XP000541623 ISSN: 0003-6951
- HAUERT R ET AL: "RESEARCH NEWS NEW COATINGS BY NANOSTRUCTURING" ADVANCED MATERIALS, VCH VERLAGSGESELLSCHAFT, WEINHEIM, DE, Bd. 11, Nr. 2, 22. Januar 1999 (1999-01-22), Seiten 175-177, XP000877985 ISSN: 0935-9648 in der Anmeldung erwähnt
- DISERENS M ET AL: "Improving the properties of titanium nitride by incorporation of silicon" 25TH INTERNATIONAL CONFERENCE ON METALLURGICAL COATINGS AND THIN FILMS, SAN DIEGO, CA, USA, 27 APRIL-1 MAY 1998, Bd. 108-109, Nr. 1-3, Seiten 241-246, XP002226793 Surface and Coatings Technology, 10 Oct. 1998, Elsevier, Switzerland ISSN: 0257-8972 in der Anmeldung erwähnt
- SCHILLER S ET AL: "VORBEHANDLUNG - BESCHICHTEN - NACHBEHANDLUNG" TECHNISCHE RUNDSCHAU, HALLWAG VERLAG. BERN, CH, Bd. 89, Nr. 3, 17. Januar 1997 (1997-01-17), Seiten 32-34, XP000681098 ISSN: 1023-0823

## Beschreibung

Die Erfindung betrifft ein Verfahren zur Erzeugung einer nanostrukturierten, insbesondere keramikartigen Funktionsbeschichtung auf einem Substrat, sowie eine damit herstellbare nanostrukturierte Funktionsbeschichtung, nach der Gattung des unabhängigen Anspruchs.

### Stand der Technik

Verschleißschutzschichten, insbesondere in Form von Hartstoffschichten auf Carbonitridbasis, sind in Einlagenaufbau oder Mehrlagenaufbau mit Schichtdicken im Mikrometerbereich sowohl auf Werkzeugen als auch auf Bauteilen bekannt.

Nachteilig bei derartigen Schichten sind die vielfach relativ hohen Reibwerte, auftretende intrinsische Spannungen und daher reduzierte Haftfestigkeiten, sowie die im Vergleich zur Härte starke Sprödigkeit. Weiter wirkt sich eine Verbesserung der Verschleißbeständigkeit durch Erhöhung der Härte bei diesen Schichten nachteilig auf andere gewünschte Eigenschaften wie Zähigkeit, Schlagbeständigkeit und Substrathaftung aus.

Neben Hartstoffschichten auf Carbonitridbasis sind reibmindernde, verschleißfeste Schichten aus diamantartigem Kohlenstoff (DLC = "diamond like carbon") und Molybdändisilizid bekannt. Deren Nachteile liegen jedoch in der vergleichsweise geringen Abrasionsbeständigkeit, einer unzureichenden Medienbeständigkeit und einer eingeschränkten Temperaturfestigkeit, die im Fall von DLC unter 350°C liegt.

Zur Überwindung der genannten Nachteile sind weiter bereits nanostrukturierte Funktionsbeschichtungen entwickelt worden, bei denen eine nanokristalline Phase vorliegt, die in eine amorphe oder kristalline Matrixphase eingebettet ist.

DE198 21364 A1 offenbart ein Verfahren bei dem eine Verschleißschutzmatrix durch Plasma gestützte chemische Dampfphasenabscheidung hergesteltt wird, in die ein funktionales Material durch PVD-Technik eingelagert wird.

Zur Herstellung derartiger, nanostrukturierter Schichten werden vor allem CVD-Verfahren ("chemical vapour deposition") und PVD-Verfahren ("physical vapour deposition") eingesetzt. Besonders die PVD-Verfahren wie Magnetronsputtern oder Arc-Verdampfen zeichnen sich durch eine große Flexibilität in der Materialauswahl aus, und bieten so die Möglichkeit, den Schichtaufbau je nach gewünschter Anwendung gezielt zu beeinflussen bzw. einzustellen.

So wird von R. Hauert et al., Advanced Materials, 11, No. 2, (1999), Seiten 175 bis 177, vorgeschlagen, über einen PAC\/D-Prozess ("plasma activated chemical vapour deposition") nanoskalige Titannitrid-Partikel mit einer Teilchengröße von 10 nm bis 20 nm in eine amorphe Siliziumnitridmatrix oder eine Matrix aus amorphem Silizium einzubetten.

M. Diserens et al., Interface and Coatings Technology, 108 bis 109, (1998), Seiten 241 bis 246, beschreiben ein PACVD-Verfahren, bei dem mittels einer Magnetronsputtertechnik ("reactiv unbalanced magnetron sputtering"), in einer Vakuumkammer auf einem Substrat bei Temperaturen von unter 350°C eine nanostrukturierte (Ti,Si)N-Schicht erzeugt wird. Konkret liegen dort nanoskalige bzw. nanokristalline Titannitrid-Partikel mit einer mittleren Kristallitgröße von ca. 20 nm in einer amorphen Silizium- oder Siliziumnitrid-Matrix eingebettet vor. Um einen zusätzlichen Energieeintrag bei der Abscheidung der Beschichtung auf dem Substrat zu gewährleisten wird dort weiter eine hochfrequente Substratspannung (Bias-Spannung) zwischen 0 V und -140 V an die zu beschichtenden Substrate angelegt.

In der von der Anmelderin stammenden Anmeldung WO 02/061165 A1 (Publikationsdatum 08.08.2002, Prioritätsdatum 02.02.2001) ist schließlich eine Vorrichtung zur keramikartigen Beschichtung eines Substrates beschrieben, mit der über eine Werkstoffquelle und ein Plasma auf einem Substrat ein Werkstoff abgeschieden wird. Dort ist eine von der Werkstoffquelle verschiedene Energiequelle zum örtlich definierten Energieeintrag in den vor und/oder auf der Oberfläche befindlichen Werkstoff vorgesehen.

### Vorteile der Erfindung

Das erfindungsgemäße Verfahren gemäß Anspruch 1 zur Erzeugung einer nanostrukturierten Funktionsbeschichtung hat gegenüber dem Stand der Technik den Vorteil, dass durch die eingesetzte gepulste Plasmaquelle eine erheblich höhere Ionendichte im Plasma erreicht wird, d.h. es sind nunmehr in einfacher Weise Schichten erzeugbar, die bei der Abscheidung eine hohe Ionendichte erfordern. Die Abscheidung derartiger Schichten ist bei herkömmlichen PACVD-Prozessen nur mit Hilfe einer zusätzlichen Ionisationsquelle möglich, die nun entfallen kann.

Insbesondere weisen die erfindungsgemäß abgeschiedenen bzw. auf dem Substrat auftreffenden Teilchen oder Atome zunächst eine relativ hohe kinetische Energie auf, die ausreichend ist, auf dem Substrat über Diffusionsprozesse nanoskalige Kristallite zu bilden, bzw. dort eine Mikrokristallitbildung fördert. Zudem wird durch die hohe Ionenenergie eine zumindest teilweise Zerschlagung von möglicherweise in den erzeugten Plasmen vorhandenen und/oder zunächst auf dem Substrat abgeschiedenen Mikrokristalliten erreicht, was ebenfalls das gewünschte nanokristalline Wachstum der Einlagerungsphase begünstigt.

Ein weiterer Vorteil des erfindungsgemäßen Verfahrens liegt darin, dass durch die eingesetzte gepulste Plasmaquelle und die damit erreichte höhere Ionisation der zur Beschichtung eingesetzten Materialien bzw. Atome die Oberflächenenergie im Bereich des zu beschichtenden Substrates gezielt auf ein für die Ausbildung des gewünschten nanostrukturierten Gefüges erforderliches Niveau einstellbar ist.

Daneben hat das erfindungsgemäße Verfahren den Vorteil einer insgesamt einfacheren Verfahrenstechnik mit einer verringerten Zahl von Anlagenkomponenten. So erlaubt es nunmehr eine weitgehend beladungsunabhängige und bauteilunabhängige Prozessführung, d. h. es ist gegenüber bekannten RF-Techniken, d. h. Verfahren, die mit einer hochfrequenten Substratelektrodenspannung arbeiten, erheblich flexibler.

Ein weiterer, wesentlicher Vorteil des erfindungsgemäßen Verfahrens liegt schließlich darin, dass das Substrat und/oder die darauf abgeschiedene Funktionsbeschichtung bei deren Erzeugung lediglich auf Temperaturen von maximal 250°C, insbesondere weniger als 200°C, aufgeheizt wird. Insofern kann vielfach auf eine zusätzliche Kühlung des Substrates bei der Schichtabscheidung ganz verzichtet werden, oder es bedarf lediglich einer üblichen Kühlvorrichtung mit vergleichsweise niedriger Kühlleistung.

Die durch das erfindungsgemäße Verfahren hergestellte, nanostrukturierte Funktionsbeschichtung hat den Vorteil, dass sie gegenüber den aus dem Stand der Technik bekannten Beschichtungen, die beispielsweise nach CVD-Verfahren hergestellt sind, frei von unerwünschten Reaktionsrückständen wie Chlorrückständen oder Schwefelrückständen von entsprechenden Prozessgasen herstellbar ist. Insbesondere ist als Reaktionsrückstand bei den insbesondere nach dem erfindungsgemäßen Verfahren hergestellten Funktionsbeschichtungen neben den erwünschten, die Zusammensetzung der erzeugten Funktionsbeschichtung definierenden Elemente wie O, H, N, C und/oder weiteren Metallen lediglich das als Plasmagas eingesetzte Edelgas darin nachweisbar.

Vorteilhafte Weiterbildungen der Erfindung ergeben sich aus den in den Unteransprüchen 2 bis 14 genannten Maßnahmen.

So ist vorteilhaft, dass mit dem erfindungsgemäßen Verfahren auf Bauteilen bzw. Zerspanwerkzeugen sowohl einlagige als auch mehrlagige Beschichtungen, insbesondere mit unterschiedlicher Zusammensetzung oder unterschiedlichen Eigenschaften, abscheidbar sind. Zudem kann die erzeugte nanostrukturierte Funktionsbeschichtung bzw. zumindest eine Teilschicht der Funktionsbeschichtung eine chemisch gradierte Zusammensetzung aufweisen, d. h. die chemische Zusammensetzung der Beschichtung ändert sich als Funktion der Schichtdicke.

Die Plasmaquelle werden hinsichtlich einer hohen Ionendichte und effizienten Abscheidung mit einer Frequenz von 20 kHz bis 70 kHz gepulst. Dabei kann die Form der eingesetzten Pulse in einfacher Weise variiert und an die jeweilige Anwendung angepasst werden, d. h. es können je nach im Einzelfall zu treffender Wahl zumindest näherungsweise rechteckförmige, trapezförmige, sägezahnförmige oder sinusförmige Pulsformen eingesetzt werden, die zudem variabel einstellbare Anstiegsfunktionen bzw. Abfallfunktionen aufweisen. Daneben erfolgt die Pulsung der eingesetzten Plasmaquellen abwechselnd bipolar.

Schließlich erfolgt das Pulsen der Plasmaquellen mit einem Puls-Pause-Verhältnis zwischen 1:4 bis 3:4, wobei die Plasmaquellen vorzugsweise mit einer Pulsspitzenleistung von 5 kW bis 40 kW betrieben werden. Außerdem kann zur Durchführung des erfindungsgemäßen Verfahrens vorteilhaft auf, abgesehen von der Pulsung, etablierte und übliche Plasmaquellen wie Sputterquellen, vorzugsweise Magnetron-Sputterquellen, oder auch Arc-Verdampferquellen zurückgegriffen werden.

Eine besonders vorteilhafte Ausführungsform des erfindungsgemäßen Verfahrens sieht den Einsatz einer Mehrzahl von zeitlich korreliert oder synchronisiert zueinander gepulst betriebenen Plasmaquellen vor, die jeweils ein Material oder eine Verbindung dem der Plasmaquelle zugeordneten Plasma zum Werkstoffeintrag auf dem Substrat, gegebenenfalls nach Reaktion mit einem Reaktivgas, zuführen. Es werden zwei oder drei Plasmaquellen eingesetzt, die abwechselnd bevorzugt bipolar gepulst betrieben werden.

Ein weiterer Vorteil des erfindungsgemäßen Verfahrens liegt schließlich darin, dass neben den gepulsten Plasmaquellen bei Bedarf auch eine zusätzliche, von den Plasmaquellen verschiedene Energiequelle zum Energieeintrag in den aus dem Plasma auf dem Substrat geschiedenen Werkstoff bzw. die erzeugte Funktionsbeschichtung, beispielsweise zur Bereitstellung einer Aktivierungsenergie für Diffusionsprozesse, eingesetzt werden kann. Dieser Energieeintrag erfolgt dann in der in WO02/061165 A1 vorgeschlagenen Weise entweder vor und/oder auf dem Substrat mittels einer Mikrowelleneinheit, einer zusätzliche Ionenquelleneinheit, einer Hohlkathodeneinheit, eine UV-Einheit zur Bestrahlung des Substrates mit UV-Licht, eines zwischen der Plasmaquelle und dem Substrat erzeugten elektrischen Feldes und/oder mittels Anlegen einer hochfrequenten Substratelektrodenspannung (Bias-Spannung).

### Zeichnungen

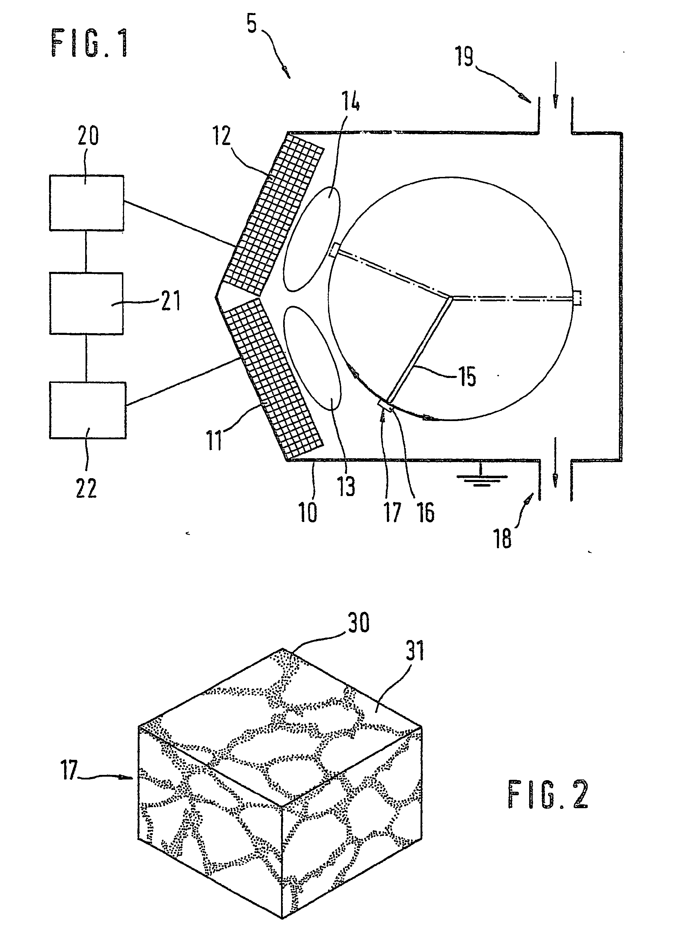

Die Erfindung wird anhand der Zeichnungen und in der nachfolgenden Beschreibung näher erläutert. Es zeigt Figur 1 eine Prinzipskizze einer Magnetron-Sputterquelle zur Durchführung des erfindungsgemäßen Verfahrens und Figur 2 eine schematische, dreidimensionale Darstellung eines Ausschnittes aus einer hergestellten Funktionsbeschichtung.

### Ausführungsbeispiele .

Die Erfindung geht aus von einer in Figur 1 dargestellten, Beschichtungsanlage 5, wie sie in ähnlicher Form auch in M. Diserens et al., Interface and Coatings Technology, 108 bis 109, (1998), Seite 242, beschrieben ist.

Im Einzelnen weist die Beschichtungsanlage 5 eine geerdete Vakuumkammer 10, eine erste Plasmaquelle 11, eine zweite Plasmaquelle 12, einen Substratträger 15 mit einem darauf befindlichen Substrat 16, einen Gasauslass 18 und einen Gaseinlass 19 auf. Weiter ist vorgesehen, dass mit der ersten Plasmaquelle 11 ein dieser zugeordnetes erstes Plasma 13, und mit der zweiten Plasmaquelle 12 ein dieser zugeordnetes zweites Plasma 14 erzeugt wird, aus denen über einen Werkstoffeintrag auf der Oberfläche des Substrates 16 eine Beschichtung 17 abgeschieden wird.

Die Figur 1 zeigt weiter, dass die erste Plasmaquelle 11 mit einer ersten Hochspannungsquelle 22 und die zweite Plasmaquelle 12 mit einer zweiten Hochspannungsquelle 20 in Verbindung steht, mit deren Hilfe die Plasmaquellen 11, 12 jeweils zunächst unabhängig voneinander pulsbar sind. Zudem ist eine mit den beiden Hochspannungsquellen 20, 22 in Verbindung stehende elektronische Steuereinheit 21 vorgesehen, die eine zeitliche Korrelation der Pulsung der beiden Plasmaquellen 11, 12 relativ zueinander, insbesondere ein abwechselndes Pulsen der beiden Plasmaquellen 11, 12, bewirkt.

Es sei an dieser Stelle betont, dass prinzipiell auch eine gemeinsame Hochspannungsquelle zur Versorgung der beiden Plasmaquellen 11, 12 ausreichend ist, die dann beispielsweise abwechselnd über die Steuereinheit 21 mit einer zur Plasmaerzeugung geeigneten Hochspannung beaufschlagt werden. Zudem kann die Steuereinheit 21 auch in eine der Hochspannungsquellen 20, 22 integriert sein.

Die Figur 2 zeigt eine mit der Beschichtungsanlage 5 erzeugte nanostrukturierte Funktionsbeschichtung 17 in einem dreidimensionalen Ausschnitt, wobei eine nanoskalige Einlagerungsphase 31 in eine Matrixphase 30 eingebettet ist.

Zur Erzeugung einer nanoskaligen Titannitrid-Einlagerungsphase 31 in eine Matrixphase 30 aus amorphem Siliziumnitrid auf einem Bauteil aus einem Metall wie Werkzeugstahl wird die erste Plasmaquelle 11 der Beschichtungsanlage 5 gemäß Figur 1 mit einer Kathode mit einem Titan-Target und die zweite Plasmaquelle 12 mit einer Kathode mit einem Silizium-Target bestückt. Gleichzeitig wird der Kammer 10 über den Gaseinlass 19 als Reaktivgas Stickstoff zugeführt, dem zusätzlich als Plasmagas Argon zugemischt ist. Weiter werden die beiden Plasmaquellen 11, 12 jeweils mit einer Pulsfrequenz zwischen 20 kHz und 70 kHz mit einem Puls-Pause-Verhältnis von 1:4 bis 3:4 abwechselnd bipolar mit trapezförmiger Pulsform gepulst.

Insbesondere ist jeweils eine der beiden Plasmaquellen 11, 12 gerade dann aktiv, wenn an der anderen eine Pulspause anliegt, d.h. die Intensität des jeweils zugeordneten Plasmas 13, 14 ein Minimum erreicht hat bzw. es am Erlöschen oder bereits erloschen ist. Die Pulsspitzenleistung der beiden Plasmaquellen 11, 12 liegt jeweils beispielsweise bei 20 kW entsprechend einer Durchschnittsleistung von 20 kW bei üblichem DC-Magnetronbetrieb.

Unter dem Pulsen des Plasmas 13 bzw. des Plasmas 14 ist somit allgemein eine zeitliche Veränderung der jeweiligen Plasmaintensität zwischen einer Maximalintensität und einer Minimalintensität zu verstehen, wobei die Minimalintensität bevorzugt durch das Erlöschen des betreffenden Plasmas 13, 14 in den Pulspausen gegeben ist. Alternativ kann die Minimalintensität auch dadurch gegeben sein, dass das jeweilige Plasma 13, 14 in den Pulspausen mit geringfügig oberhalb zum Erlöschen führender Verfahrensparameter betrieben wird, so dass es zwar nicht erlischt, die Minimalintensität aber erheblich niedriger als die Maximalintensität ist.

Die Plasmaquellen 11, 12 sind bevorzugt Sputterquellen, deren Effizienz durch ein Magnetron verstärkt ist, d.h. sie Zerstäuben jeweils einen als Kathode oder Target eingesetzten Werkstoff. Dieser ist beispielsweise einerseits ein von einer Plasmaquelle 11, 12 bereitgestelltes Metall oder ein Metalloxid, insbesondere Titan, Chrom, Kupfer oder Zirkonium, sowie andererseits von der jeweils anderen Plasmaquelle 11, 12 bereitgestelltes Silizium oder Kohlenstoff. Prinzipiell ist jedoch auch lediglich eine Plasmaquelle 11, 12 mit einem entsprechenden Target sowie einem geeigneten Reaktivgas zur Durchführung des erfindungsgemäßen Verfahrens bzw. zur Abscheidung einer nanostrukturierten Funktionsbeschichtung ausreichend. Bevorzugt werden jedoch zwei oder mehr Plasmaquellen 11, 12 mit vorzugsweise zeitlich getaktet zugesetzten Reaktivgasen eingesetzt.

Die Figur 1 zeigt schließlich, dass das Substrat 16 bevorzugt auf einem rotierenden Substratträger 15 angeordnet ist, so dass es periodisch an den beiden Plasmaquellen 11, 12 mit ihrem jeweils zugeordneten Plasma 13, 14 vorbeigeführt wird. Somit stellt sich bei dem Vorbeiführen des Substrates 16 in dem Einwirkungsbereich der Plasmen 13, 14 jeweils ein Werkstoffeintrag auf die Oberfläche des Substrates 16 ein.

Im Übrigen sei erwähnt, dass die Erzeugung der FunktionsbeSchichtung 17 in der Kammer 10 vorzugsweise bei einem Arbeitsdruck von 10⁻⁴ hPa (mbar) bis 10⁻² hPa (mbar), beispielsweise 10⁻³ hPa (mbar), erfolgt. Dazu sind geeignete, nicht dargestellte Mittel zur Gewährleistung eines entsprechenden Vakuums in der Kammer 10 vorgesehen. Das Substrat 16 ist beispielsweise ein metallisches Substrat, insbesondere ein metallisches Bauteil oder ein Zerspanwerkzeug, das über den Substratträger 16 elektrisch leitend mit der geerdeten Kammer 10 in Verbindung steht.

Durch das erläuterte Beschichtungsverfahren wird insgesamt erreicht, dass Substrat und/oder die Funktionsbeschichtung 17 auf dem Substrat auf eine Temperatur von weniger als 200°C, insbesondere lediglich ca. 150°C, aufgeheizt wird.

Durch Analyse der Struktur der wie beschrieben erzeugten Beschichtung 17 wurde festgestellt, dass sich eine weitgehend amorphe Matrixphase 30 aus Siliziumnitrid eingestellt hat, in die eine nanoskalige bzw. nanokristalline Titannitrid-Einlagerungsphase 31 eingebettet ist.

Die mittlere Korngröße der Einlagerungsphase 31 liegt dabei je nach Verfahrensführung bei ca. 1 nm bis ca. 100 nm, vorzugsweise ca. 3 nm bis ca. 30 nm.

Je nach Wahl des Materials für die Matrixphase 30 ist es weiter auch möglich anstelle einer amorphen Matrixphase 30 eine metallische, mikrokristalline oder kristalline Matrixphase 30 zu erzeugen.

Als Material für die Matrixphase 30 kommt neben dem beschriebenen Silizium bzw. Siliziumnitrid auch ein Metall, eine Legierung, Molybdändisilizid, amorpher Kohlenstoff oder DLC in Frage.

Als Material für die nanoskalige Einlagerungsphase 31 eignet sich neben Titannitrid auch ein Metalloxid, ein anderes Metallnitrid, ein Metallcarbid, ein Metallcarbonitrid oder eine andere Hartstoffphase, insbesondere Zirkoniumnitrid, Siliziumnitrid, Titancarbid, Siliziumcarbid, Titanoxid, Chromoxid, Zirkoniumoxid oder Tantaloxid.

Bevorzugt sind die Kombinationen Siliziumnitrid als Matrixphase 30 und Titannitrid als nanoskalige Einlagerungsphase 31 oder ein Metall wie Kupfer als Matrixphase 30 und Zirkoniumnitrid als nanoskalige Einlagerungsphase 31.

Die Zusammensetzung der zu erzeugenden bzw. abzuscheidenden Matrixphase 30 sowie der nanoskaligen Einlagerungsphase 31 hängt neben den von den Plasmaquellen 11, 12 bereitgestellten Werkstoffen von dem den Plasmen 13, 14 zugeführten Reaktivgas ab. Dieses ist beispielsweise der bereits erwähnte, über den Gaseinlass 19 zugeführte Stickstoff oder alternativ Sauerstoff, Wasserstoff oder ein kohlenstoffhaltiges Gas, insbesondere ein Kohlenwasserstoff. Dem Reaktivgas ist weiter bevorzugt ein Plasmagas wie Argon oder Helium zugesetzt. Es sei jedoch betont, dass auf Zufuhr eines Reaktivgases je nach den von den Plasmaquellen 11, 12 bereitgestellten Werkstoffen und der gewünschten Zusammensetzung der Funktionsbeschichtung 17 prinzipiell auch verzichtet werden kann, beispielsweise bei Verwendung eines Metalloxids als Kathode oder Target in einer der Plasmaquellen 11, 12. In diesem Fall wird der Kammer 10 lediglich das Plasmagas zugeführt.

Weiterhin ist klar, dass durch Variation des dem ersten Plasma 13 bzw. dem zweiten Plasma 14 zugeführten Materials als Funktion der Zeit, beispielsweise durch Veränderung der Art oder Menge des zugeführten Reaktivgases, eine aus mehreren Teilschichten mit unterschiedlicher Zusammensetzung aufgebaute Funktionsbeschichtung 17 abscheidbar ist. Daneben ist es auch möglich, durch gezielte, insbesondere kontinuierliche Veränderung der Art und/Menge des zugeführten Reaktivgases eine chemisch gradierte Zusammensetzung der Funktionsbeschichtung 17 bzw. der einzelnen Teilschichten zu erzeugen.

Eine Weiterführung der vorstehend erläuterten Ausführungsbeispiele sieht vor, neben den Plasmaquellen 11, 12 eine zusätzliche, von diesen verschiedene Energiequelle zum Energieeintrag in den aus den Plasmen 13, 14 auf dem Substrat 16 abgeschiedenen Werkstoff zu verwenden, wobei dieser Energieeintrag in den vor und/oder auf dem Substrat 16 befindlichen, die Beschichtung 17 bildenden Werkstoff erfolgt. Als Energiequelle eignen sich die bereits in WO 02/061165 A1 beschriebenen Einrichtungen, d.h. beispielsweise eine Mikrowelleneinheit, eine Ionenquelleneinheit, eine Hohlkathodeneinheit, eine UV-Einheit, ein Mittel zur Erzeugung eines elektrischen Feldes zwischen der Plasmaquelle 11, 12 und dem Substrat 16 und/oder eine Hochfrequenzspannungsquelle zum Beaufschlagen des Substrates 16 mit einer hochfrequenten Substratspannung (Bias-Spannung) gegen Erde.

Insgesamt mit der Hilfe der erläuterten Ausführungsbeispiele stets eine nanostrukturierte, insbesondere keramische, qualitativ hochwertiges Schicht 17 oder ein entsprechendes Schichtsysteme auf dem Substrat 16 erhalten, die neben der nanoskaligen Einlagerungsphase 31 in einem weiteren Gefüge eine Matrixphase 30 umfasst, die bevorzugt amorph oder metallisch in Form eines refraktären Netzwerkes ausgebildet ist, die aber auch kristallin sein kann. Dabei ist der Anteil des Oberflächenvolumens der Einlagerungsphase 31 am Gesamtvolumen sehr hoch, und die Grenzflächen zwischen den Nanokristalliten der Einlagerungsphase 31 und der umgebenden, insbesondere amorphen Matrix 30 sind vergleichsweise scharf. Insbesondere werden durch Einlagerung einer solchen, nanoskaligen Hartstoffphase Beschichtungen 17 mit Härten von über 4000 HV erhalten, die eine durch die erzeugte Nanostrukturierung reduzierte Sprödheit aufweisen.

Die Dicke der wie erläutert erzeugten Funktionsbeschichtung 17 auf dem Substrat 16 liegt üblicherweise im Bereich von 100 nm bis 10 µm, insbesondere 500 nm bis 5 µm, wobei neben dieser zwischen dem Substrat 16 und der Funktionsbeschichtung 17 zusätzliche noch eine an sich bekannte haftvermittelnde Zwischenschicht bzw. auf der Funktionsbeschichtung 17 eine Deckschicht oder Einlaufschicht, beispielsweise auf amorphem Kohlenstoff, vorgesehen sein kann.

Als Substrat 16 kommen zudem neben planaren Substraten 16 auch dreidimensionale Bauteile wie Bohrer, Wellen, Lagerkomponenten, Kolben, Zahnräder oder dergleichen in Frage.

## Patentansprüche

1. Verfahren zur Erzeugung einer nanostrukturierten Funktionsbeschichtung (17) auf einem Substrat (16), wobei mit wenigstens zwei Plasmaquellen (11, 12) jeweils ein gepulstes Plasma (13, 14) erzeugt wird, mit denen auf dem Substrat (16) über einen Werkstoffeintrag eine amorphe, metallische, mikrokristalline oder kristalline Matrixphase (30) und mindestens eine, darin eingebettete, nanoskalige Einlagerungsphase (31) abgeschieden wird, wobei Pulse mit zumindest näherungsweise rechteckförmiger, trapezförmiger, sägezahnförmiger oder sinusförmiger Pulsform und/oder Pulsformen mit unterschiedlicher Anstiegs- und Abfallfunktion eingesetzt werden,
**dadurch gekennzeichnet.**
**dass** als Plasmaquellen (11, 12) abwechselnd bipolar gepulste Magnetron-Sputterquellen eingesetzt und mit einer Frequenz von 20 bis 70 kHz und mit einem Puls-Pause-Verhältnis von 1:4 bis 3:4 gepulst werden, wobei die eine Plasmaquelle (11, 12) aus Metall oder Metalloxid und die andere Plasmaquelle aus Silizium oder Kohlenstoff besteht, und als Reaktivgas Stickstoff, Sauerstoff, Wasserstoff oder ein kohlenstoffhaltiges Gas eingesetzt wird, und eine nanokristalline Einlagerungsphase (31) mit einer mittleren Korngröße von 1 nm bis 100 nm abgeschieden wird.

2. Verfahren nach Anspruch 1, **dadurch gekennzeichnet, dass** die Plasmaquellen (11, 12) mit einer Pulsspitzenleistung von 5 kW bis 40 kW betrieben werden.

3. Verfahren nach Anspruch 1 oder 2, **dadurch gekennzeichnet, dass** die mindestens zwei Plasmaquellen (11, 12) zeitlich korreliert oder synchronisiert zueinander gepulst werden.

4. Verfahren nach einem der Ansprüche 1 bis 3, **dadurch gekennzeichnet, dass** als Reaktivgas Kohlenwasserstoff zugeführt wird.

5. Verfahren nach einem der Ansprüche 1 bis 4, **dadurch gekennzeichnet, dass** eine zusätzliche, von den Plasmaquellen (11, 12) verschiedene Energiequelle zum Energieeintrag in den aus dem Plasma (13, 14) auf dem Substrat (16) abgeschiedenen Werkstoff eingesetzt wird, wobei dieser Energieeintrag in den vor und/oder auf dem Substrat (16) befindlichen Werkstoff erfolgt.

6. Verfahren nach Anspruch 5, **dadurch gekennzeichnet, dass** der Energieeintrag über eine Mikrowelleneinheit, eine Ionenquelleneinheit, eine Hohlkathodeneinheit, eine UV-Einheit oder ein zwischen einer der Plasmaquellen (11, 12) und dem Substrat (16) erzeugtes elektrisches Feld erfolgt und/oder dass das Substrat (16) mit einer insbesondere hochfrequenten Substratspannung beaufschlagt wird.

7. Verfahren nach einem der Ansprüche 1 bis 6, **dadurch gekennzeichnet, dass** die Erzeugung der Funktionsbeschichtung in einer Vakuumkammer (10) bei einem Arbeitsdruck von 10⁻⁴ hPa (mbar) bis 10⁻² hPa (mbar) erfolgt.

8. Verfahren nach einem der Ansprüche 1 bis 7, **dadurch gekennzeichnet, dass** die Erzeugung der Funktionsbeschichtung (17) derart erfolgt, dass das Substrat (16) und/oder die Funktionsbeschichtung (17) auf dem Substrat (16) auf eine Temperatur von maximal 250°C, insbesondere maximal 200°C, aufgeheizt wird.

9. Verfahren nach einem der Ansprüche 1 bis 8, **dadurch gekennzeichnet, dass** das Substrat (16) auf einem beweglichen oder rotierenden Substratträger (15) angeordnet, und insbesondere periodisch an den Plasmaquellen (11, 12) mit ihrem jeweils zugeordneten Plasma (13, 14) vorbeigeführt wird, wobei das Substrat (16) dem jeweiligen Plasma (13, 14) zum Werkstoffeintrag ausgesetzt wird.

10. Verfahren nach einem der Ansprüche 1 bis 9, **dadurch gekennzeichnet, dass** eine nanokristalline Einlagerungsphase (31) mit einer mittleren Korngröße von 3 nm bis 30 nm abgeschieden wird.

11. Verfahren nach einem der Ansprüche 1 bis 10, **dadurch gekennzeichnet, dass** eine Matrixphase (30) aus einem Metall oder einer Legierung, einem Siliziumnitrid, MOSi₂, amorphem Kohlenstoff oder DLC ("diamond like carbon") erzeugt wird, in die als nanoskalige Einlagerungsphase (31) ein Metalloxid, ein Metallnitrid, ein Metallcarbid, ein Metallcarbonitrid oder eine andere Hartstoffphase, insbesondere Zirkoniumnitrid, Siliziumnitrid, Titannitrid, Titancarbid, Siliziumcarbid, Titanoxid, Chromoxid, Zirkoniumoxid oder Tantaloxid, eingebettet ist.

12. Verfahren nach einem der Ansprüche 1 bis 11, **dadurch gekennzeichnet, dass** eine aus mehreren Teilschichten aufgebaute Funktionsbeschichtung (17) abgeschieden wird.

13. Verfahren nach einem der Ansprüche 1 bis 12, **dadurch gekennzeichnet, dass** die Funktionsbeschichtung (17) und/oder zumindest einzelne Teilschichten der Funktionsbeschichtung (17) mit einer chemisch gradierten Zusammensetzung erzeugt werden.

14. Verfahren nach einem der Ansprüche 1 bis 13, **dadurch gekennzeichnet, dass** die Funktionsbeschichtung (17) auf einem metallischen Substrat (16), insbesondere einem Bauteil oder zerspanwerkzeug, abgeschieden wird.

## Claims

1. Method for producing a nanostructured functional coating (17) on a substrate (16), wherein at least two plasma sources (11, 12) are used to produce a respective pulsed plasma (13, 14), by means of which an amorphous, metallic, microcrystalline or crystalline matrix phase (30) and at least one nanoscale incorporation phase (31) embedded therein are deposited on the substrate (16) by means of material introduction, wherein pulses having an at least approximately rectangular, trapezium-shaped, sawtooth-shaped or sinusoidal pulse shape and/or pulse shapes having different rise and fall functions are used,
**characterized**
**in that** magnetron sputtering sources pulsed in bipolar fashion alternately are used as plasma sources (11, 12) and are pulsed with a frequency of 20 to 70 kHz and with a mark-space ratio of 1:4 to 3:4, wherein one plasma source (11, 12) comprises metal or metal oxide and the other plasma source comprises silicon or carbon, and nitrogen, oxygen, hydrogen or a carbon-containing gas is used as reactive gas, and a nanocrystalline incorporation phase (31) having an average grain size of 1 nm to 100 nm is deposited.

2. Method according to Claim 1, **characterized in that** the plasma sources (11, 12) are operated with a pulse peak power of 5 kW to 40 kW.

3. Method according to Claim 1 or 2, **characterized in that** the at least two plasma sources (11, 12) are pulsed in temporally correlated or synchronized fashion with respect to one another.

4. Method according to any of Claims 1 to 3, **characterized in that** hydrocarbon is fed in as reactive gas.

5. Method according to any of Claims 1 to 4, **characterized in that** an additional energy source that is different from the plasma sources (11, 12) is used for inputting energy into the material deposited on the substrate (16) from the plasma (13, 14), wherein this energy input is effected into the material situated in front of and/or on the substrate (16).

6. Method according to Claim 5, **characterized in that** the energy input is effected by means of a microwave unit, an ion source unit, a hollow cathode unit, a UV unit or an electric field generated between one of the plasma sources (11, 12) and the substrate (16), and/or in that an in particular high-frequency substrate voltage is applied to the substrate (16).

7. Method according to any of Claims 1 to 6, **characterized in that** the functional coating is produced in a vacuum chamber (10) at a working pressure of 10⁻⁴ hPa (mbar) to 10⁻² hPa (mbar).

8. Method according to any of Claims 1 to 7, **characterized in that** the functional coating (17) is produced in such a way that the substrate (16) and/or the functional coating (17) on the substrate (16) is heated to a temperature of at most 250°C, in particular at most 200°C.

9. Method according to any of Claims 1 to 8, **characterized in that** the substrate (16) is arranged on a movable or rotating substrate carrier (15), and in particular is guided periodically past the plasma sources (11, 12) with their respectively assigned plasma (13, 14), wherein the substrate (16) is exposed to the respective plasma (13, 14) for the introduction of material.

10. Method according to any of Claims 1 to 9, **characterized in that** a nanocrystalline incorporation phase (31) having an average grain size of 3nm to 30 nm is deposited.

11. Method according to any of Claims 1 to 10, **characterized in that** a matrix phase (30) is produced from a metal or an alloy, a silicon nitride, MOSi₂, amorphous carbon or DLC ("diamondlike carbon"), into which is embedded, as nanoscale incorporation phase (31), a metal oxide, a metal nitride, a metal carbide, a metal carbonitride or some other hard material phase, in particular zirconium nitride, silicon nitride, titanium nitride, titanium carbide, silicon carbide, titanium oxide, chromium oxide, zirconium oxide or tantalum oxide.

12. Method according to any of Claims 1 to 11, **characterized in that** a functional coating (17) constructed from a plurality of partial layers is deposited.

13. Method according to any of Claims 1 to 12, **characterized in that** the functional coating (17) and/or at least individual partial layers of the functional coating (17) are produced with a chemically graded composition.

14. Method according to any of Claims 1 to 13, **characterized in that** the functional coating (17) is deposited on a metallic substrate (16), in particular a component or chipping tool.

## Revendications

1. Procédé de formation d'un revêtement fonctionnel nanostructuré (17) sur un substrat (16), dans lequel au moins deux sources de plasma (11, 12) forment chacune un plasma pulsé (13, 14) par lesquels une phase amorphe, métallique, microcristalline ou cristalline (30) et au moins une phase (31) d'inclusions à échelle nanométrique incorporée dans la phase de matrice sont déposées, en utilisant des impulsions qui présentent une forme au moins approximativement rectangulaire, trapézoïdale, en dents de scie ou sinusoïdale et/ou des formes d'impulsion qui présentent des fonctions différentes de montée et de descente,
**caractérisé en ce que**
comme sources de plasma (11, 12), on utilise en alternance des sources de pulvérisation à magnétron à impulsion bipolaire et d'une fréquence de 20 à 70 kHz avec un rapport entre les impulsions et les pauses de 1:4 à 3:4, l'une des sources de plasma (11, 12) étant constituée d'un métal ou d'un oxyde métallique et l'autre source de plasma étant constituée de silicium ou de carbone, en utilisant comme gaz réactif de l'azote, de l'oxygène, de l'hydrogène ou un gaz contenant du carbone, la phase nanocristalline d'inclusions (31) déposée présentant une granulométrie moyenne de 1 nm à 100 nm.

2. Procédé selon la revendication 1, **caractérisé en ce que** les sources de plasma (11, 12) fonctionnent à une puissance de pointe d'impulsion de 5 kW à 40 kW.

3. Procédé selon les revendications 1 ou 2, **caractérisé en ce que** les deux ou plusieurs sources de plasma (11, 12) sont pulsées en corrélation temporelle ou en synchronisation mutuelle.

4. Procédé selon l'une des revendications 1 à 3, **caractérisé en ce que** l'on apporte comme gaz réactif un hydrocarbure.

5. Procédé selon l'une des revendications 1 à 4, **caractérisé en ce que** l'on utilise une source d'énergie supplémentaire, différente des sources de plasma (11, 12), pour apporter de l'énergie dans le matériau déposé sur le substrat (16) à partir du plasma (13, 14), cet apport d'énergie s'effectuant dans le matériau situé devant et/ou sur le substrat (16).

6. Procédé selon la revendication 5, **caractérisé en ce que** l'apport d'énergie s'effectue à l'aide d'une unité à micro-ondes, d'une unité de source d'ions, d'une unité à cathode creuse, d'une unité à UV ou d'un champ électrique formé entre l'une des sources de plasma (11, 12) et le substrat (16), et/ou **en ce qu'**une tension de substrat en particulier à haute fréquence est appliquée sur le substrat (16).

7. Procédé selon l'une des revendications 1 à 6, **caractérisé en ce que** la formation du revêtement fonctionnel s'effectue dans une chambre sous vide (10) à une pression de travail de 10⁻⁴ hPa (mbar) à 10⁻² hPa (mbar).

8. Procédé selon l'une des revendications 1 à 7, **caractérisé en ce que** le revêtement fonctionnel (17) est formé en chauffant le substrat (16) et/ou le revêtement fonctionnel (17) disposé sur le substrat (16) à une température d'au plus 250°C et en particulier d'au plus 200°C.

9. Procédé selon l'une des revendications 1 à 8, **caractérisé en ce que** le substrat (16) est disposé sur un porte-substrat (15) mobile ou rotatif et est passé en particulier périodiquement devant les sources de plasma (11, 12) et les plasmas (13, 14) qui leurs sont associés, le substrat (16) étant exposé à chaque plasma (13, 14) pour l'apport de matériau.

10. Procédé selon l'une des revendications 1 à 9, **caractérisé en ce qu'**une phase nanocristalline d'inclusions (31) d'une granulométrie moyenne de 3 nm à 30 nm est déposée.

11. Procédé selon l'une des revendications 1 à 10, **caractérisé en ce qu'**une phase de matrice (30) constituée d'un métal ou d'un alliage, de nitrure de silicium, de MOSi₂, de carbone amorphe ou de DLC ("diamond like carbon" - carbone de type diamant) est formée, dans laquelle sont incorporés comme phase nanométrique d'inclusions (31), un oxyde métallique, un nitrure métallique, un carbure métallique, un carbonitrure métallique ou une autre phase de matériau dur, en particulier le nitrure de zirconium, le nitrure de silicium, le nitrure de titane, le carbure de titane, le carbure de silicium, l'oxyde de titane, l'oxyde de chrome, l'oxyde de zirconium ou l'oxyde de tantale.

12. Procédé selon l'une des revendications 1 à 11, **caractérisé en ce qu'**un revêtement fonctionnel (17) constitué de plusieurs couches partielles est déposé.

13. Procédé selon l'une des revendications 1 à 12, **caractérisé en ce que** le revêtement fonctionnel (17) et au moins certaines couches partielles du revêtement fonctionnel (17) sont formés avec une composition chimique à gradient.

14. Procédé selon l'une des revendications 1 à 13, **caractérisé en ce que** le revêtement fonctionnel (17) est déposé sur un substrat métallique (16) et en particulier sur un composant ou un outil de décolletage.
